Europäisches Patentamt

European Patent Office

Office européen des brevets

(11) Veröffentlichungsnummer: **0 281 795**
**A1**

## (12) EUROPÄISCHE PATENTANMELDUNG

(21) Anmeldenummer: 88102162.0

(22) Anmeldetag: 15.02.88

(51) Int. Cl.⁴: **G01R 13/34 , G01M 11/00**

(30) Priorität: 25.02.87 CH 718/87

(43) Veröffentlichungstag der Anmeldung:
**14.09.88 Patentblatt 88/37**

(84) Benannte Vertragsstaaten:
**CH DE FR GB LI**

(71) Anmelder: **BBC Brown Boveri AG**
**Haselstrasse**
**CH-5401 Baden(CH)**

(72) Erfinder: **Heimgartner, Dieter**
**Mattächer 16**
**CH-5453 Remetschwil(CH)**
Erfinder: **Kaufmann, Meinolph**
**Moosstrasse 11**
**CH-5406 Baden(CH)**
Erfinder: **Schad, Hanspeter, Dr.**
**Boldistrasse 6**
**CH-5415 Rieden(CH)**

(54) **Verfahren zum Abtasten eines zeitlich veränderlichen elektrischen Signals sowie Vorrichtung zur Durchführung und Anwendung des Verfahrens.**

(57) Bei einem Verfahren zur Abtastung eines zeitlich veränderlichen elektrischen Signals wird ein Elektronenstrahl (12) seitlich linear mit der Zeit ausgelenkt und gleichzeitig in seiner Intensität gemäss der augenblicklichen Amplitude des elektrischen Signals moduliert. Der Elektronenstrahl (12) erzeugt auf einem Leuchtschirm (14) einen helligkeitsmodulierten Lichtbalken, der vorzugsweise mit einem vor dem Leuchtschirm (14) angeordneten Sensor (15) in Form einer CCD-Zeilenkamera mit einem linearen Array aus Sensorelementen (15a, b, c) abgetastet wird.

Die ausgelesenen analogen Abtastwerte des Sensors (15) werden anschliessend digitalisiert und weiterverarbeitet.

Der Vorteil des Verfahrens liegt in seiner hohen Breitbandigkeit und Auflösung und der Möglichkeit, eine Mittelung ohne zusätzlichen Zeitaufwand durchführen zu können.

FIG.2

# Verfahren zum Abtasten eines zeitlich veränderlichen elektrischen Signals sowie Vorrichtung zur Durchführung und Anwendung des Verfahrens

## Technisches Gebiet

Die Erfindung bezieht sich generell auf das Gebiet der Messtechnik. Sie betrifft speziell ein Verfahren zum Abtasten eines zeitlich veränderlichen elektrischen Signals, eine Vorrichtung zur Durchführung dieses Verfahrens sowie eine Anwendung des Verfahrens.

## Stand der Technik

In der faseroptischen Messtechnik ist es seit längerem bekannt, das Dämpfungsverhalten von Glasfasern mit Hilfe der sogenannten zeitlich aufgelösten Rückstreumessung (OTDR = Optical Time Domain Reflectrometry) zu untersuchen und den Dämpfungsverlauf entlang der Faser zu bestimmen (siehe z.B. S.D. Personick in "The Bell Systems Technical Journal", Vol. 56, No. 3, März 1977, S. 355-366).

Bei solchen OTDR-Messungen werden kurze Lichtpulse in die zu untersuchende Glasfaser eingekoppelt. Durch die elastische und unelastische Streuung (Rayleigh-und Raman-Streuung) beim Durchlauf des Lichtpulses durch die Faser entsteht ein Rückstreusignal, das am Fasereingang ausgekoppelt und mittels eines Photodetektors (z.B. einer Avalanche-Photo-Diode APD) in ein entsprechendes elektrisches Signal umgewandelt wird.

Es ist nun weiterhin bekannt, OTDR-Messungen an Glasfasern (Lichtwellenleitern) zur ortsaufgelösten Temperaturmessung heranzuziehen (siehe z.B. Electronics Letters, Vol. 21, No. 13, Juni 1985, S. 569, 570). Hierbei wird aus dem Rückstreusignal der sehr schwache, temperaturabhängige Anteil der Ramanstreuung herausgefiltert und mit einem üblichen Boxcar-oder Transientenrecorder-Averager das im Photodetektor entstehende, zeitabhängige elektrische Signal vom Rauschen befreit, um dann weiterverarbeitet werden zu können.

Bei diesen herkömmlichen Verfahren der Signalabtastung und -mittelung durch einen Boxcar-Averager oder Transientenrecorder werden für die Aufbereitung der stark verrauschten Signale lange Integrations-bzw. Mittelungszeiten in der Grössenordnung von Minuten bis Stunden benötigt, da die Mittelwertbildung ausschliesslich digital erfolgt und einen separaten Vorgang darstellt.

Die Vor-und Nachteile der bekannten Verfahren können in einer Uebersicht wie folgt aufgelistet werden:

### A. Boxcar-Averager

Vorteile: - sehr hohe Bandbreite;
- kein zusätzlicher Zeitaufwand durch die Mittelung, da diese Wert für Wert erfolgt;
- die Wiederholzeit bei periodischer Abtastung ist daher nicht durch den Mittelungsprozess begrenzt;

Nachteile: - bei periodischen Abtastvorgängen kann nur ein Messwert pro Periode, d.h. ein Kurvenpunkt, erfasst werden;
- für eine längere Signalkurve sind sehr viele Wiederholungsmessungen nötig;
- die Auflösung ist mit 6 - 8 bit gering.

### B. Transientenrecorder-Averager

Vorteile: - der gesamte Kurvenzug eines Signals wird innerhalb einer Messperiode aufgenommen; es können daher auch einzelne Signale ohne Wiederholung abgetastet werden;

Nachteile:

- die Bandbreite ist durch den A/D-Wandler auf etwa 100 MHz begrenzt;
- die Auflösung ist mit 6 - 8 bit gering;
- es wird für die Mittelung zusätzliche Zeit benötigt, wodurch die Wiederholzeit begrenzt wird.

Bezüglich des für die Abtastung erforderlichen Zeitbedarfs lässt sich beispielhaft, wenn man eine Mittelung über 1000 Kurvenzüge mit 1000 Abtastpunkten pro Kurvenzug zugrundelegt, für die bekannten Verfahren folgendes sagen:

Ein Boxcar-System benötigt bei einer Wiederholfrequenz von 10 kHz eine Zeit von 100 s, ein Transientenrecorder-System mit einer Averaging-Rate von 100 kSamples/s benötigt 10 s, wobei in diesem Fall die Wiederholfrequenz wegen der nachgeschalteten Mittelung auf 100 Hz begrenzt ist.

Aus den oben genannten Ausführungen lässt sich entnehmen, dass die beiden herkömmlichen Abtastverfahren, gerade auch im Bezug auf ihre Möglichkeiten der Mittelung, sehr zeitaufwendig und darüber hinaus mit geringer Auflösung ausgestattet sind.

## Darstellung der Erfindung

Aufgabe der vorliegenden Erfindung ist es nun, ein Abtastverfahren für elektrische Signale und eine Vorrichtung zur Durchführung des Verfahrens anzugeben, welche mit hoher Band breite und Auflösung arbeiten und eine sehr schnelle Mittelung bei sich wiederholenden Signalen ermöglichen.

Die Aufgabe wird bei einem Verfahren der eingangs genannten Art durch die folgenden Schritte gelöst:
- ein Elektronenstrahl steuerbarer Intensität wird seitlich linear mit der Zeit ausgelenkt;
- die Intensität des Elektronenstrahl wird während der Auslenkung gemäss der augenblicklichen Amplitude des elektrischen Signals moduliert;
- der Elektronenstrahl wird entlang einem aus einer Mehrzahl von nebeneinander angeordneten Sensorelementen bestehenden· Sensor ausgelenkt; und
- die örtlich· variierende Intensität des Elektronenstrahls wird mittels der Sensorelemente in elektrische, analoge Abtastwerte umgewandelt und in dieser Form weiterverarbeitet.

Die erfindungsgemässe Vorrichtung zur Durchführung des Verfahrens umfasst
- eine Elektronenstrahlröhre;
- in der Elektronenstrahlröhre Mittel zur Modulation der Intensität des Elektronenstrahls;
- eine Ablenkeinrichtung zur Auslenkung des Elektronenstrahls;
- einen aus einer Mehrzahl nebeneinander angeordneten Sensorelementen bestehender Sensor, welcher an der Elektronenstrahlröhre derart angeordnet ist, dass der ausgelenkte Elektronenstrahl an den Sensorelementen nacheinander entlangfährt;
- eine Zeitbasis zur Steuerung der Ablenkeinrichtung; und
- einen Datenprozessor zur Verarbeitung der beim Abtastetn im Sensor anfallenden Abtastwerte.

Gemäss einem bevorzugten Ausführungsbeispiel für die Vorrichtung
- weist die Elektronenstrahlröhre einen Leuchtschirm auf;
- ist der Sensor eine CCD-Zeilenkamera, welche neben den Sensorelementen entsprechende, den Sensorelementen zugeordnete Speicherelemente enthält, die ein CCD-Schieberegister bilden.

In einer Anwendung wird das erfindungsgemässe Verfahren zur Signalaufbereitung der bei zeitaufgelösten, optischen Rückstreumessungen an Glasfasern, insbesondere für die ortsaufgelöste Temperaturmessung auftretenden Rückstreusignale eingesetzt.

Weitere Ausgestaltungen der Erfindungen ergeben sich aus den Unteransprüchen.

Der Kern der Erfindung besteht darin, die zeitliche Abtastung des elektrischen Signals auf dem Umweg über die Modulation und Steuerung des Elektronenstrahls in eine örtliche Abtastung überzuführen. Die Strahlsteuerung kann trägheitslos und extrem breitbandig ausgeführt werden. Der ortsverteilte Sensor ermöglicht eine direkte, analoge Mittelung der Abtastwerte pro Sensorelement ohne zusätzlichen Zeitaufwand.

Mit der Erfindung ergeben sich die folgenden Vorteile:
- mit der Helligkeits-(Intensitäts-)Modulation werden eine hohe Auflösung und Dynamik erreicht;
- die Mittelung erfolgt ohne zusätzlichen Zeitaufwand, da sie analog erfolgt;
- es kann eine hohe Bandbreite erreicht werden (bei Standard-Elektronenröhren bis 180 MHz, bei Spezialröhren entsprechend höher);
- die Abtastwerte brauchen nur einmal, nach der Mittelung, über einen A/D-Wandler ausgelesen zu werden;
- die Bedienung kann ähnlich einfach und komfortabel wie bei einem Oszilloskop ausgeführt werden (z.B. mit Zoom-oder Delayfunktion);
- das Verfahren ist auch zum Abtasten von einzelnen Signalen geeignet.

## Kurze Beschreibung der Zeichnung

Nachfolgend soll die Erfindung anhand von Ausführungsbeispielen im Zusammenhang mit der Zeichnung näher erläutert werden.

Es zeigen:

Fig. 1 den prinzipiellen Aufbau eines bekannten OTDR-Messsystems;

Fig. 2 in perspektivischer Darstellung den Aufbau einer Elektronenstrahlröhre mit aufgesetztem Sensor gemäss einem bevorzugten Ausführungsbeispiel der Erfindung;

Fig. 3 den prinzipiellen Aufbau einer Anordnung zum Abtasten von elektrischen Signalen gemäss einer Ausführungsform der Erfindung; und

Fig. 4 die Struktur einer als Sensor in der erfindungsgemässen Vorrichtung eingesetzten CCD-Zeilenkamera.

## Wege zur Ausführung der Erfindung

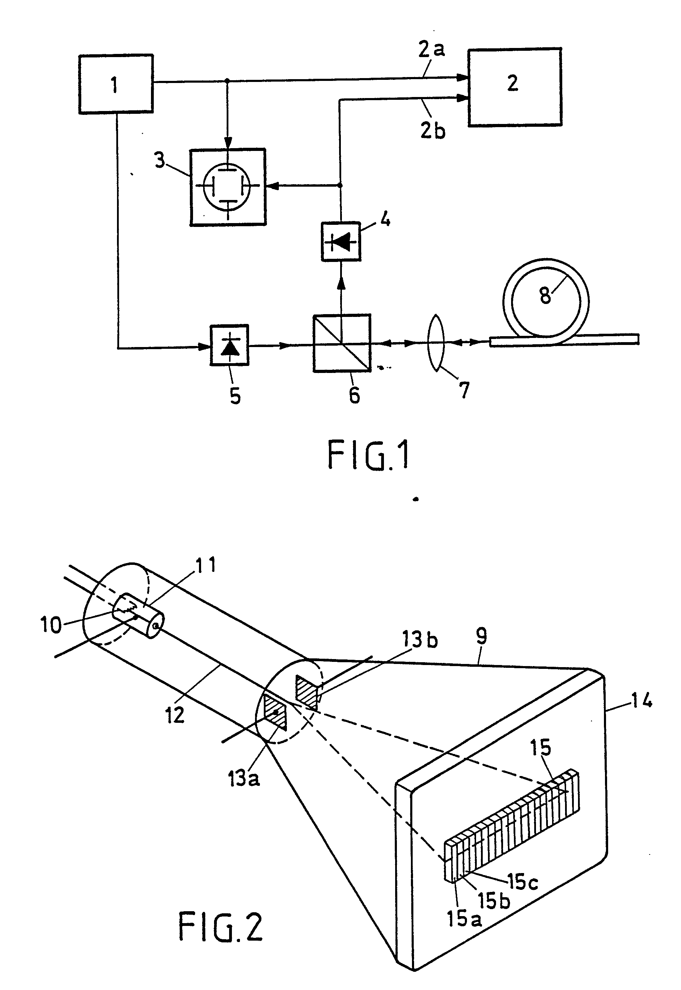

Für die OTDR-Messung, wie sie eingangs bereits beschrieben worden ist, wird üblicherweise eine Messanordnung verwendet, deren prinzipieller Aufbau in Fig. 1 dargestellt ist.

Messobjekt ist hierbei eine Glasfaser 8, welche, angedeutet durch die Wicklung, eine Länge von vielen Metern bis Kilometern haben kann. Auf der Eingangsseite der Glasfaser 8 wird über eine Einkoppel-Optik 7 Licht sowohl ein-, als auch das resultierende Rückstreusignal wieder ausgekoppelt (dargestellt durch den Doppelpfeil).

Das für die Messung verwendete Licht in Form kurzer Lichtpulse stammt beispielsweise aus einer Laserdiode 5, die von einem Impulsgeber 1 gesteuert wird. Zwischen der Laserdiode 5 und der Einkoppel-Optik 7 ist ein Strahlteiler angeordnet, welcher den aus der Laserdiode 5 stammenden primären Lichtpuls ungehindert passieren lässt, den zurückkommenden Rückstreuimpuls, welcher die Information über das Dämpfungsverhalten der Glas faser 8 enthält, jedoch seitlich herausspiegelt und auf einen Photodetektor, beispielsweise eine Avalanche-Photo-Diode (APD) 4 lenkt.

In der Avalanche-Photo-Diode 4 wird das ankommende Lichtsignal in ein entsprechendes elektrisches Signal umgewandelt und wahlweise auf einem Oszilloskop 3 dargestellt oder in einer Signalverarbeitungseinheit 2 ausgewertet. Sowohl das Oszilloskop 3 als auch die Signalverarbeitungseinheit 2 sind zur Synchronisation mit dem Impulsgeber 1 verbunden. Das in Fig. 1 dargestellte allgemeine OTDR-System muss entsprechend modifiziert werden, wenn es zur ortsaufgelösten Temperaturmessung entlang der Glasfaser 8 herangezogen werden soll. Eine wesentliche Modifikation besteht in diesem Fall darin, zwischen dem Strahlteiler 6 und der Avalanche-Photo-Diode 4 eine wellenlängenselektive Vorrichtung (z.B. einen Monochromator) einzufügen, um die zur Auswertung benötigten, schwachen Raman-Anteile aus dem Rückstreuspektrum herauszufiltern.

Bei dieser Art von Messung stehen am Ausgang der Avalanche-Photo-Diode 4, wie man leicht einsehen kann, äusserst schwache und zudem stark verrauschte Signale zur Verfügung, die erst einem zeitraubenden Abtast-und Mittelungsprozess unterworfen werden müssen, um eine für die Auswertung geeignete Qualität zu ereichen. Im Stand der Technik werden zu diesem Zweck Verfahren angewendet (Boxcar oder Transientenrecorder), bei denen das zeitlich veränderliche elektrische Signal direkt abgetastet, digitalisiert und anschliessend digital gemittelt wird.

Die Erfindung geht hier nun einen gänzlich anderen Weg, der wie ein Umweg anmutet, aber gegenüber den bekannten Verfahren wesentliche Vorteile aufweist. Kernstück der Erfindung ist eine Kombination aus einer Elektronenstrahlröhre 9 und einem ortsempfindlichen Sensor 15 (Fig. 2).

Die Elektronenstrahlröhre 9 gleicht vorzugsweise in Aufbau und Ausstattung einer üblichen Oszilloskop-Röhre mit einer Elektronenquelle 10 und einer elektrostatischen Ablenkeinrichtung mit mindestens einem Paar von Ablenkplatten 13a, b. Es sei an dieser darauf hingewiesen, dass anstelle einer elektrostatisch wirkenden ebensogut eine magnetisch wirkende Ablenkeinrichtung eingesetzt werden kann.

Neben der Ablenkeinrichtung zur Auslenkung des Elektronenstrahls 12 sind weiterhin in der Elektronenstrahlröhre 9 Mittel zur Modulation der Intensität des Elektronenstrahls 12 vorgesehen, wie sie z.B. aus Oszilloskopen mit z-Eingang (Helligkeitssteuerung) bekannt sind. Diese können insbesondere die Form eines sogenannten Wehnelt-Zylinder 11 haben, über den die Stärke des Elektronenstrahls 12 beeinflusst wird.

Beim erfindungsgemässen Verfahren wird nun der Elektronenstrahl 12 in der Elektronenstrahlröhre 9 mittels der Ablenkplatten 13a, b linear mit der Zeit ausgelenkt (sägezahnförmige Ablenkspannung). Während dieser Auslenkung wird seine Intensität mit dem Augenblickswert der Amplitude des abzutastenden elektrischen Signals moduliert. Auf diese Weise beschreibt der Elektronenstrahl mit wechselnder Intensität eine gerade Linie auf der Frontseite der Elektronenstrahlröhre 9.

Auf dieser Frontseite ist vorzugsweise ein Leuchtschirm 14 angebracht, welcher die Spur des intensitätsmodulierten Elektronenstrahls 12 in einen helligkeitsmodulierten Lichtbalken umwandelt.

Dieser helligkeitsmodulierte Lichtbalken wird mit einem vor dem Leuchtschirm 14 angeordneten lichtempfindlichen und ortsauflösenden Sensor 15 abgetastet, welcher aus einer Mehrzahl von nebeneinander angeordneten Sensorelementen 15a, b, c besteht.

Die örtlich variierende Helligkeit des Lichtbalkens führt in den verschiedenen Sensorelementen 15a, b, c zu analogen Signalen entsprechend unterschiedlicher Stärke, aus denen beim Auslesen wieder ein dem Eingangssignal vergleichbares elektrisches Ausgangssignal gewonnen werden kann.

Der entscheidende Vorteil dieses Umweges über die Elektronenoptik wird deutlich, wenn man in die Ueberlegungen das Problem der Mittelung über sich periodisch wiederholende Signale einbezieht: Beim erfindungsgemässen Verfahren kann die Mittelung analog nach Art einer Integration für jedes Sensorelement 15a, b, c unmittelbar und ohne zusätzlichen Zeitaufwand durchgeführt werden, wodurch der Zeitaufwand bei der Signalregeneration im ortsaufgelösten Temperaturmessverfahren gegenüber herkömmlichen Techniken drastisch verringert werden kann, ohne an Auflösung und Bandbreite einzubüssen.

Besonders günstig kann das Verfahren realisiert werden, wenn als Sensor 15 eine sogenannte CCD-Zeilenkamera (CCD = Charge Coupled Device) eingesetzt wird. In einer solchen CCD-Zeilenkamera sind jedem photoempfindlichen Sensorelement eines linearen Arrays entsprechende Speicherelemente zugeordnet, die zusammen ein CCD-Schieberegister bilden, in welchem die Photosignale einzeln aufintegriert und anschliessend hintereinander ausgelesen und digitalisiert werden können. Die ganze Anordnung bildet so einen optischen Vielkanalanalysator mit extremer Bandbreite und Mittelungsschnelligkeit.

Je nach Feinheit des Elektronenstrahl 12 kann der Sensor 15 entweder direkt auf dem Leuchtschrim 14 angebracht werden oder über eine verkleinernde Zwischenoptik mit dem Leuchtschirm 14 optisch verbunden sein. Es sind darüber hinaus auch integrierte Versionen denkbar, bei denen der Sensor 15 direkt im Vakuumgefäss der Elektronenstrahlröhre 9 untergebracht ist. Ausserdem ist es möglich, ohne den Umweg über den Leucht schirm 14 und die Photodetektion den Elektronenstrahl direkt mit einem für Elektronen empfindlichen Sensor zu detektieren. Ein solches Dioden-Array ist z.B. unter der Bezeichnung "Reticon" von der Firma EG + G, USA erhältlich (siehe z.B. die Application Note No. 101 der Firma EG + G Reticon, Sunnyvale, Ca, USA).

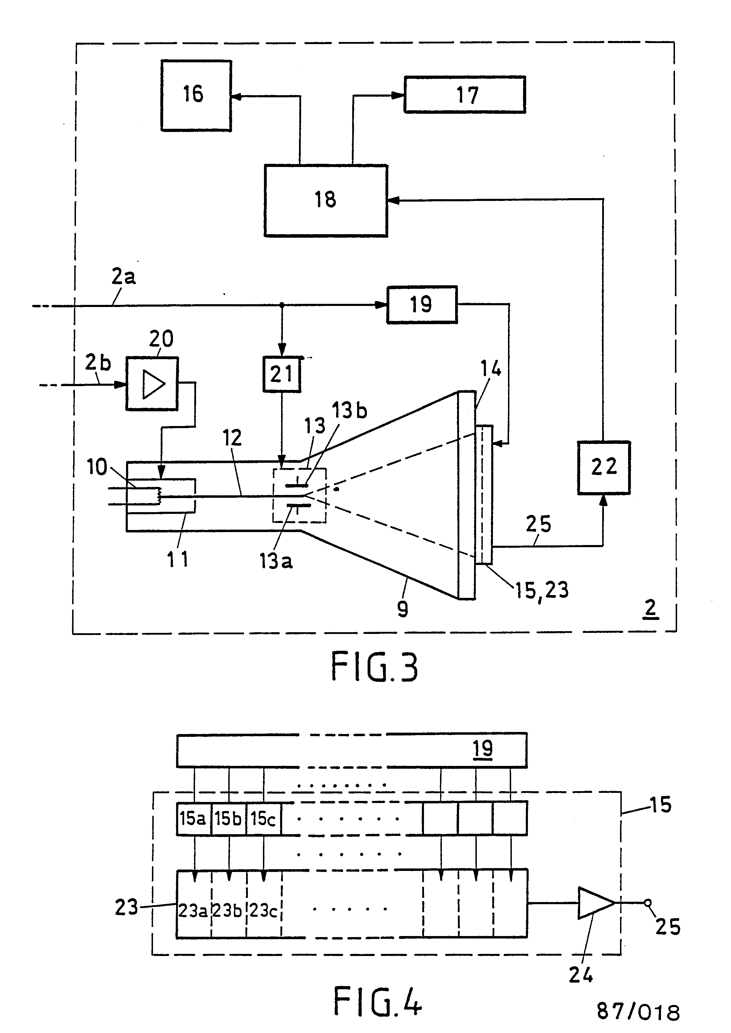

Mit der Kombination aus Elektronenstrahlröhre 9 und Sensor 15 kann nun eine wirkungsvolle Signalverarbeitungseinheit 2 in einer OTDR-Anordnung nach Fig. 1 aufgebaut werden. Eine solche Signalverarbeitungseinheit 2 ist im Prinzipschaltbild in Fig. 3 wiedergegeben.

Das elektrische Rückstreusignal aus der Avalanche-Photo-Diode 4 (Fig. 1) gelangt über einen Signaleingang 2b auf einen Breitbandverstärker 20, wird dort verstärkt und zur Steuerung des Wehnelt-Zylinders 11 an die Elektronenstrahlröhre 9 weitergegeben. Da die Helligkeitssteuerung mittels Wehnelt-Zylinder auf einer nichtlinearen Kennlinie verläuft, muss der Breitbandverstärker 20 in seinem Uebertragungsverhalten entsprechend ausgelegt sein, um diese Nichtlinearität zu kompensieren.

Vom Impulsgeber 1 (Fig. 1) wird jeweils ein geeigneter Triggerimpuls über einen Triggereingang 2a auf eine Zeitbasis 21 und eine Sensorsteuerung 19 gegeben. Die Zeitbasis 21 erzeugt eine für die zeitlineare Auslenkung des Elektronenstrahls 12 notwendige Steuerspannung, die der Ablenkeinrichtung 13 der Elektronenstrahlröhre 9 mit den Ablenkplatten 13a, b zugeführt wird.

Die Sensorsteuerung 19 übernimmt die Steuerung des Sensors 15, d.h., setzt die Speicherelemente vor einer Messung auf Null und steuert das Auslesen der gespeicherten Mess-und Mittelwerte. Der detaillierte Aufbau der Sensorsteuerung 19 richtet sich nach der Art des Sensors 15 und kann im Falle einer CCD-Zeilenkamera den Applikationsblättern der Sensorhersteller entnommen werden.

Die analogen, gemittelten Abtastwerte der Sensorelemente erscheinen beim Auslesen nacheinander an einem Sensorausgang 25, werden von dort an einen A/D-Wandler 22 weitergeleitet, digitalisiert, und schliesslich in einem Datenprozessor 18 ausgewertet. Hinter dem Datenprozessor 18 können ein Bildschirmgerät 16 zur bildlichen Darstellung des gesamten Rückstreusignals und eine Datenausgabeeinheit 17 angeordnet sein, an welcher die aus dem Rückstreusignal gewonnenen Glasfaserparameter (bei einer allgemeinen OTDR-Messung) oder die Temperaturverteilung entlang der Glasfaser (bei einer ortsaufgelösten Temperaturmessung) ausgegeben werden.

In Fig. 4 ist noch einmal veranschaulicht, wie im Falle der CCD-Zeilenkamera die Sensorsteuerung 19 und der Sensor 15 zusammenwirken. Der Sensor 15 enthält die lichtempfindlichen Sensorelemente 15a, b, c in einem linearen Array. Jedem der Sensorelemente 15a, b, c ist ein entsprechendes Speicherelement 23a, b, c zugeordnet. Die Speicherelemente 23a, b, c bilden zusammen ein CCD-Schieberegister 23.

Die Sensorsteuerung 19 wirkt direkt auf jede aus dem Sensorelement 15a, b, c und dem zugehörigen Speicherelement 23a, b, c gebildete Zelle des Sensors 15. Beim Auslesen werden sukzessive die gespeicherten, analogen Ladungswerte im CCD-Schieberegister 23 nach rechts verschoben, in einem Ausgangsverstärker 24 verstärkt und auf den Sensorausgang 25 gegeben.

Es ist weiterhin auch denkbar, anstelle einer Elektronenoptik mit einer Lichtoptik zu arbeiten, d.h. einen Lichtstrahl in der Helligkeit zu modulieren und z.B. mit einem Drehspiegel linear auszulenken.

Insgesamt wird mit der Erfindung eine extrem breitbandige, hochauflösende und sehr schnelle Abtastung eines elektrischen Signals ermöglicht, wobei insbesondere die unmittelbare analoge Mittelung bei periodisch wiederkehrenden Signalen hervorzuheben ist.

## Ansprüche

1. Verfahren zum Abtasten eines zeitlich veränderlichen, elektrischen Signals, gekennzeichnet durch die folgenden Schritte:

    a) ein Elektronenstrahl (12) steuerbarer Intensität wird seitlich linear mit der Zeit ausgelenkt;

    b) die Intensität des Elektronenstrahls (12) wird während der Auslenkung gemäss der augenblicklichen Amplitude des elektrischen Signals moduliert;

c) der Elektronenstrahl (12) wird entlang einem aus einer Mehrzahl von nebeneinander angeordneten Sensorelementen (15a, b, c) bestehenden Sensor (15) ausgelenkt; und

d) die örtlich variierende Intensität des Elektronenstrahls (12) wird mittels der Sensorelemente (15a, b, c) in elektrische, analoge Abtastwerte umgewandelt und in dieser Form weiterverarbeitet.

2. Verfahren nach Anspruch 1, dadurch gekennzeichnet, dass

a) mehrere gleichartige elektrische Signale nacheinander abgetastet werden;

b) die Abtastwerte jeweils für jedes der Sensorelemente (15a, b, c) direkt in analoger Form gemittelt werden; und

c) die gemittelten Abtastwerte anschliessend nacheinander ausgelesen und digitalisiert werden.

3. Verfahren nach Anspruch 2, dadurch gekennzeichnet, dass zur Mittelung der Abtastwerte die Abtastwerte jeweils unmittelbar von jedem Sensorelement (15a, b, c) in ein dem Sensorelement (15a, b, c) zugeordnetes Speicherelement (23a, b, c) überführt werden.

4. Verfahren nach Anspruch 1, dadurch gekennzeichnet, dass als Sensor (15) ein für Elektronen empfindliches Photo dioden-Array verwendet und der Elektronenstrahl (12) direkt über den Sensor (15) geführt wird.

5. Verfahren nach Anspruch 1, dadurch gekennzeichnet, dass mit dem ausgelenkten, intensitätsmodulierten Elektronenstrahl (12) auf einem Leuchtschirm (14) ein helligkeitsmodulierter Lichtbalken erzeugt und mit einem hinter dem Leuchtschirm (14) angeordneten, lichtempfindlichen Sensor (15) abgetastet wird.

6. Vorrichtung zur Durchführung des Verfahrens gemäss Anspruch 1, umfassend:

a) eine Elektronenstrahlröhre (9);

b) in der Elektronenstrahlröhre (9) Mittel zur Modulation der Intensität des Elektronenstrahls (12);

c) eine Ablenkeinrichtung (13) zur Auslenkung des Elektronenstrahls;

d) einen aus einer Mehrzahl nebeneinander angeordneten Sensorelementen (15a, b, c) bestehender Sensor (15), welcher an der Elektronenstrahlröhre (9) derart angeordnet ist, dass der ausgelenkte Elektronenstrahl (12) an den Sensorelementen (15a, b, c) nacheinander entlangfährt;

e) eine Zeitbasis (21) zur Steuerung der Ablenkeinrichtung (13); und

f) einen Datenprozessor (18) zur Verarbeitung der beim Abtasten im Sensor (15) anfallenden Abtastwerte.

7. Vorrichtung nach Anspruch 6, dadurch gekennzeichnet, dass

a) die Modulationsmittel einen Wehnelt-Zylinder (11) umfassen,

b) die Ablenkeinrichtung (13) ein Paar von Ablenkplatten (13a, b) aufweist; und

c) zur Steuerung des Wehnelt-Zylinders (11) ein Breitbandverstärker (20) vorgesehen ist, welcher die nichtlineare Kennlinie des Wehnelt-Zylinders (11) kompensiert.

8. Vorrichtung nach Anspruch 7, dadurch gekennzeichnet, dass

a) die Elektronenstrahlröhre (9) einen Leuchtschirm (14) aufweist;

b) der Sensor (15) eine CCD-Zeilenkamera ist, welche neben den Sensorelementen (15a, b, c) entsprechende, den Sensorelementen (15a, b, c) zugeordnete Speicherelemente (23a, b, c) enthält, die ein CCD-Schieberegister (23) bilden;

c) der Sensor (15) vor dem Leuchtschirm (14) der Elektronenstrahlröhre (9) angeordnet ist;

d) der Abtastvorgang im Sensor (15) durch eine Sensorsteuerung (19) gesteuert wird, welche insbesondere auf das CCD-Schieberegister (23) einwirkt; und

e) dem Sensor (15) ein A/D-Wandler (22) nachgeschaltet ist, welcher die aus dem CCD-Schieberegister (23) ausgelesenen analogen Abtastwerte digitalisiert und an den Datenprozessor (18) weiterleitet.

9. Anwendung des Verfahrens nach Anspruch 1 zur Signalaufbereitung der bei zeitaufgelösten, optischen Rückstreumessungen an Glasfasern, insbesondere für die ortsaufgelöste Temperaturmessung auftretenden Rückstreusignale.

FIG.1

FIG.2

FIG.3

FIG.4

87/018

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | WO-A-8 300 933 (D.I. SPALDING) * Seite 5, Zeile 23 - Seite 6, Zeile 20; Seite 7, Zeilen 3-15,20-26; Seite 8, Zeile 21 - Seite 9, Zeile 6; Figuren 1,2,4 * | 1,4-8 | G 01 R 13/34 G 01 M 11/00 |
| Y | | 9 | |
| A | --- | 2,3 | |
| D,Y | THE BELL SYSTEM TECHNICAL JOURNAL, Band 56, Nr. 3, März 1977, Seiten 355-366, American Telephone and Telegraph Co., US; S.D. PERSONICK: "Photon probe - An optical-fiber time-domain reflectometer" * Figur 1 * | 9 | |
| X | --- FR-A-2 331 794 (THOMSON-CSF) * Seite 2, Zeilen 21-27; Seite 3, Zeile 21 - Seite 4, Zeile 7; Figur 1 * | 1,4-8 | |
| D,A | --- ELECTRONICS LETTERS, Band 21, Nr. 13, 20. Juni 1985, Seiten 569-570; J.P. DAKIN et al.: "Distributed optical fibre Raman temperature sensor using a semiconductor light source and detector" * Zusammenfassung; Figur 3 * | 9 | RECHERCHIERTE SACHGEBIETE (Int. Cl.4) G 01 R G 01 M |
| A | --- JEE, Band 23, Nr. 236, August 1986, Seiten 62-65; K. KITAGAWA: "OTDR makes breakthrough in accuracy and dynamic range" * Figur 2; Photo 3 * ----- | 9 | |

Der vorliegende Recherchenbericht wurde für alle Patentansprüche erstellt

| Recherchenort | Abschlußdatum der Recherche | Prüfer |
|---|---|---|
| DEN HAAG | 31-05-1988 | PENZKOFER,B. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
......................................................................
& : Mitglied der gleichen Patentfamilie, übereinstimmendes Dokument